(19) Europäisches Patentamt
European Patent Office
Office européen des brevets

(11) **EP 2 302 658 A2**

(12) **EUROPEAN PATENT APPLICATION**
published in accordance with Art. 153(4) EPC

(43) Date of publication:
**30.03.2011 Bulletin 2011/13**

(51) Int Cl.:
***H01J 29/02*** *(2006.01)*

(21) Application number: **09750737.0**

(22) Date of filing: **15.05.2009**

(86) International application number:
**PCT/KR2009/002583**

(87) International publication number:
**WO 2009/142415 (26.11.2009 Gazette 2009/48)**

(84) Designated Contracting States:
**AT BE BG CH CY CZ DE DK EE ES FI FR GB GR
HR HU IE IS IT LI LT LU LV MC MK MT NL NO PL
PT RO SE SI SK TR**
Designated Extension States:
**AL BA RS**

(30) Priority: **21.05.2008 KR 20080047798**

(71) Applicant: **Lim, Byung Yun
201-1002 Hyundai 2nd APT
Yongam-dong
Sangdang-gu
Cheongju-city
Chungbuk 360-812 (KR)**

(72) Inventor: **LIM, Soo Hyun
Chungbuk 360-812 (KR)**

(74) Representative: **TBK-Patent
Bavariaring 4-6
80336 München (DE)**

(54) **ELECTROMAGNETIC SHIELDING OF TVS, COMPUTERS AND CELLULAR/CORDLESS PHONES, SPECTACLES, FACE SHIELDS AND SCREEN PROTECTORS**

(57) Although electromagnetic waves from TVs, computers or cellular phones are significant dangers to people's health, despite remarkable advances in the performance of electronic products, no product has yet been developed to shield electromagnetic waves sufficiently and to deter their effects on people's health. The present invention is therefore directed to a technique for shielding electromagnetic waves from cellular/cordless phones, TVs and computer screens, and to electromagnetic shielding spectacles, face shields and screen protectors. The present invention is built based on a new principle of electromagnetic shielding by blending a transparent material with a ferromagnetic or ferrimagnetic material comprising a single magnetic domain and micro particles with light transparency, such that it can sufficiently shield all kinds of electromagnetic waves including magnetic waves that are even more harmful than electric waves but are regarded as impossible to shield by conventional techniques. Unlike the conventional thin coating deposition methods that can only shield a part of electromagnetic waves, the present invention can sufficiently shield harmful electromagnetic waves and selectively pass only visible rays, which is achieved by blending particulate phase or fibrous electromagnetic shielding materials directly with transparent glass materials or with synthetic resin materials for the thick screen of a TV, computer and cellular/cordless phone, or for the see-through portion of spectacles, face shield and screen protector. Such a transparent electromagnetic shielding material in use has a particle size in a range between 0.2nm and 200nm, preferably between 0.2nm and 20nm. A conductive layer having a volume resistance not greater than $10^{10}$ $\Omega$m is also used, and an electromagnetic shielding material for spectacles and face shields has a specific resistance not greater than $10^{11}$ $\Omega$m. In case of a portable/cordless phone, the side of the phone facing a user engaged or not engaged in a call is shielded with an electromagnetic shielding material, while a part or all of the antenna area on the rear side of the phone is not shielded with an electromagnetic shielding material to enable transmission/receiving. With the present invention, harmful electromagnetic waves from TVs, computers or cellular/cordless phones that used to be regarded as difficult to avoid can sufficiently shielded, thereby opening a new world of health benefits.

**(Cont. next page)**

Figure 2

**Description**

Technical Field

The present invention relates to shielding the electromagnetic waves from cellular or cordless phones, TVs and computer screens, and related equipments such as electromagnetic shielding spectacles, face shields and screen protectors that help protect human health from the electromagnetic waves from TVs and computers.

The present invention is a new method that aims to shield electromagnetic waves by blending transparent materials with ferromagnetic materials that have a single magnetic domain and light transparency, where even magnetic waves that, despite being much more harmful than electric waves, could not be shielded by conventional methods can be shielded.

The cellular phones referred to in the present invention include all kinds of cellular phones, even smart phones and PDAs, and the cordless phones in the present invention refer to home-use cordless phones.

Background Art

These days, harmful electromagnetic waves are one of the biggest threats to human health, the most representative of which is the electromagnetic waves from TVs, computers and cellular phones.

Although these electronic appliances are the symbol of the science civilization, the electromagnetic waves from these appliances harm human health and cause a variety of physical and mental illnesses. In spite of that, no technique has been developed yet that shields electromagnetic waves, especially harmful magnetic waves, so that no product has been launched yet that protects human health from the electromagnetic waves from TVs, computers, cellular phones and cordless phones.

Checking through past patent applications for spectacles, an invention titled "Eye Shield That Protects Eyes from Computer Monitors" (Application no. 20-2004-0028913 filed on Oct 14, 2004) was applied for patent. But this invention is little different in its effect from the conventional coating technique in that it inserts a thin film of electromagnetic shielding material between dual lenses. Aside from that, another patent applied for, "Silver-Nano Spectacles" (Application no. 20-2005-0010399 filed on April 14, 2005), was actually aimed at preventing germ proliferation using Silver's sterilization effect, rather than shielding electromagnetic waves.

Up to now, the electromagnetic shielding methods upon transparent materials such as TV screens have been limited only to coating a very thin conductive layer or a thin vacuum-deposited metal film of less than 1 on the screen, where only a limited amount of electric waves could be shielded and, more important, the more harmful magnetic waves could not be shielded due to the thin layer or film and inappropriate shielding material.

In order to effectively shield the electromagnetic waves from TVs and computer monitor screens, the present inventor applied for a patent of Korean Patent Application No. 10-2005-0008292 with the title of "Shielding the electromagnetic waves from TVs and computer monitors" in Jan 26, 2005.

The above invention is the first to adopt a method of shielding electromagnetic waves on the screen by blending electromagnetic shielding materials with the thick materials of the screen. At the same time, the above invention is the first to enable shielding electromagnetic waves on transparent materials using ferrites or ferrates.

However, the appropriate particle size range for securing light transparency in blending electromagnetic shielding materials is not presented in the above invention, nor is the appropriate conduction standard necessary for shielding electric waves presented.

Another thing to be made clear is that the above invention does not cover how to prevent electromagnetic waves from cellular phones and cordless phones. In addition, inventions of spectacles or face shields for protecting the eyes and head of a user and an electromagnetic shielding screen protector attachable on the screen are not included in the above patent so that the techniques to prevent electromagnetic waves from already produced TVs and computers are not yet applied for patent.

In order to solve the problems above, the present inventor dug more to the invention of the Application No. 10-2005-0008292 above. As a result, the standard of the electromagnetic shielding materials could be established that uses ferromagnetic particulates or fibers such as permanently magnetic or temporarily magnetic particulates, and as a result of the research on the correlation between the wavelength of light and the particle size of the electromagnetic shielding materials, the appropriate particle size range necessary for securing the transparency for visible rays was found out. In addition, the method capable of shielding harmful X-rays or ultraviolet rays and the standard of volume resistance necessary for shielding electric waves was also established so that the present invention comes to be applied for a patent that can sufficiently shield all the harmful electromagnetic waves from the screens of TVs, computers, cellular phones, and cordless phones. Furthermore, the present invention comes to be applied for a patent for the spectacles, face shields and screen protectors using the same electromagnetic shielding principle. Moreover, additional methods were established that shield the electromagnetic waves from cellular phones or cordless phones on the screens and bodies of the phones.

The present invention enables sufficient shielding against the harmful electromagnetic waves from TVs, computers, cellular phones and cordless phones, thereby protecting human health from the electromagnetic waves that people have been helplessly exposed to.

Disclosure

Technical problem

There have not been any products that enabled sufficient shielding against the harmful electromagnetic waves from the screens of TVs, computers, cellular phones or cordless phones, nor have been any spectacles, face shields or screen protectors that can sufficiently shield the harmful electromagnetic waves from TVs and computers. That is why people have been exposed to a variety of diseases such as dizziness, eye illnesses, fetal malformations, abortion, the mental illnesses like ADHD, VDT syndromes and cardiovascular diseases, cancers. Those threats to human health are also the abundant harmful electromagnetic waves from the latest screens such as LCDs as well as from the conventional Braun-tube screens.

The threat of the electromagnetic waves to the humankind is a problem that only recently started to emerge, leading to a lack of accumulated research data and history. So even the electromagnetic waves below the permission standards cannot be considered absolutely safe because they cause a lot of illnesses to people because international safety standards are continuously reinforced.

The established consensus is that there is no absolute safe threshold value when it comes to exposure to radiation or electromagnetic waves so that, for the sake of health, it is necessary to reduce electromagnetic waves as much as possible even if it is below the permissible standards.

Even though the volumes of the electromagnetic waves generated from TVs and computers are different from one another, it is usually 10~180V/M at a distance of 30~50cm while the international permissible standard is 1~10V/M according to frequency bands. The volume of magnetic waves generated is usually 1~2mG while the permissible standard is 0.25-2mG according to frequency bands.

When it comes to the volume of the electromagnetic waves generated from cellular phones, we have a research titled "Research on safety standards of electromagnetic waves from cordless terminals" released in the Feb. 1998 copy of Wave Development, showing that a value of 28.2V/M was measured at a distance of 2mm.

According to the book 'Electromagnetic Waves That Threat You' published by 'HanSeung' in May 30, 1997, Karolinska reported a correlation between the strength of electromagnetic waves and leukemia, where it was proved that the attack rate of childhood leukemia was 3.8 times higher where the strength of electromagnetic waves was measured above 3mG, and 2.7 times higher where the strength of electromagnetic waves was above 2mG, 2.1 times higher where the strength of electromagnetic waves was 1~1.9mG.

In addition, we have a Bulteris report also showing that the attack rate of adult leukemia was 3.04 times higher where the strength of electromagnetic waves was above 2.9mG.

As can be seen from the above, the attack rate of leukemia was 2.1 times higher where the strength of electromagnetic waves was above 1mG so that even 1mG of electromagnetic wave is considered to be very harmful. Therefore, complete shielding against electromagnetic waves is very important for the sake of health even if its strength is only minimal.

While electric waves can be shielded with relative ease, but more harmful magnetic waves are not shielded easily.

Just a little amount of magnetic waves can be very harmful to people. Electric waves are easily shielded by conductive materials and the human body is also a conductive object, which means that electric waves have more influence on the conductive human skin rather than on the inner parts of the human body which is influenced more by electric charges generated from electric waves rather than by direct electric waves. However, magnetic waves are much more harmful in that they are not shielded easily and they are penetrating enough to directly harm human's inner parts, which is supported by many case researches.

For electric waves, the frequency band that has the strongest heating effect is the micro frequency band of 300MHz~30GHz.

Generally the frequency of the 800MHz band and 2GHz band are used for cellular phones so that the temperature around the user's head increases in calling where just 10 minutes of calling with the phone beside the head can cause dizziness. And the longer people use cellular phones, the more they are likely to have brain tumors so that a research shows that those who used cellular phones more than ten years were more than twice likely to have brain tumors.

And even though the electric waves from computer screens are not as concentrated as the electric waves from cellular phones, just 1~2 hours of computer use can also cause dizziness, hyperemia or pain of eyes, and several hours of computer use intensifies fatigue.

It is also to be noted that a long time of computer use can go to a variety of illnesses, as supported by a case where a computer user who had played computer games for nine consecutive hours died suddenly on blood clots, and also supported by many other cases that computer users who had played computer games for days in a row died on the blood clots generated by electric waves.

Also, even the electromagnetic waves generated from the low frequency of 50~60hz for home use are very harmful to the human body as can been seen from users of the conventional electric blankets or electric mats.

In May 20, 2008, Chosun Ilbo, a Korean daily paper, posted an article quoting an article of Independent's May 18, 2008 copy as reporting that according to a research conducted by a joint research team of U.C.L.A of the U.S and Arjus Univ. of Denmark on 13,159 Dannish females who gave birth in the late 1990s, the children born of the females who had used cellular phones 2~3 times a day was 54% more behavior difficulty illnesses than the others, and if the children born of the females who had used cellular phones in their pregnant periods start to use cellular phones before 7 years old, they are 80% more to suffer mental and physical illnesses than the others.

Munhwa Ilbo, another Korea's daily newspaper, posted in their March 25, 2008 copy a research saying that the strength of the electromagnetic waves from home-use cordless phones are 52 times higher than those of cellular phones.

In addition, Dr. Salford of Sweden Rund Univ. released his research on BBC in Feb 5, 2003 that the electric waves from cellular phones cause damage to the brain part of mice that controls learning, memory and exercise movement. He conducted an experiment where 12~26 week-old mice were exposed to the electromagnetic waves of the same strength as that of the cellular phone electromagnetic waves for 2 hours, and he found 50 days later that many brain cells of the mice were dead. So he insisted that the electromagnetic waves from cellular phones can cause the same damage to the human as Alzheimer disease, given that the brain of mice is similar to that of humans.

According to an article reported in the Sep 18, 2009 copy of Korea Economy News, the strength of electromagnetic waves measured at Internet PC cafes around Seoul was up to 17 times higher than the international permission standard. According to an inspection of the Seoul metropolitan office conducted by Lawmaker Ryu Seong Geun(Hannara party), the strength of electromagnetic waves measured in an Internet PC cafe in the Seong Dong District was 3mG at the entrance and 15~35mG at each side, which is up to 17 times higher than the 2mG allowed in the international permission standard.

And the Lawmaker Ryu also claimed that the strength of electromagnetic waves measured in Internet PC cafes around the DaeHak Avenue was also as high as 4~20 mG.

Conventional electromagnetic shielding coating adopts the method of applying a thin layer of electric shielding material on the screen, where while some electric waves can be shielded, but much more harmful and penetrating magnetic waves cannot be shielded. In addition, no technique has been done to shield the electromagnetic waves from cellular phones or cordless phones.

The electromagnetic waves from TVs, computers, cellular phones and cordless phones are a mix of electric waves and magnetic waves so that, for successful shielding against electromagnetic waves, such techniques have to be adopted that enable successful shielding against both electric waves and magnetic waves.

The objectives of the present invention are as follows.

The first objective is to research principles related with shielding magnetic waves and establish the most efficient way for transparent materials to shield magnetic waves.

The second objective is to find out the appropriate particle size necessary for insuring the transparency of light.

The third objective is to set the standard of the conduction necessary for shielding electric waves.

The fourth objective is to devise ways that enable sufficient shielding even against other harmful high-energy electromagnetic waves such as UV rays or X-rays.

The fifth objective is to find out ways to minimize phone users' exposure to the electromagnetic waves from cellular phones or cordless phones in their calling mode or waiting mode.

The present invention aims to prevent human health from the electromagnetic waves from TVs, computers, cellular phones and cordless phones that put human health in serious danger.

Technical solution

The present invention uses the following methods in order to sufficiently shield electric waves and magnetic waves.

For shielding or reducing electromagnetic waves on the screens of TVs, computers, cellular phones and cordless phones, spectacles, face shields, and screen protectors, at least one of particle or fiber of metal kind, particle or fiber of metal kind alloys, particle or fiber of metal kind compounds, particle or fiber of ferrite or ferrate, particle or fiber of ferrite or ferrate alloys, particle or fiber of ferrite or ferrate compounds, particle or fiber of carbon, and particle or fiber of fine ceramics as electromagnetic shielding materials is blended with the material used for the screens, shielding spectacles, face shields, screen protectors within a thick and transparent glass material or synthetic resin material that form a millimeters-thick electromagnetic shielding layer while the shielding materials to be used are required to contain more than one of ferromagnetic or ferrimagnetic materials.

Within the transparent matter, the electromagnetic shielding material to be used is required to have a particle size in the range between 0.2nm and 200nm, preferably between 0.2nm and 20nm. It features shielding or reducing harmful electromagnetic waves using more than one of conductive layers of electric volume resistance no greater than $10^{10}$ $\Omega$m, while no greater than $10^{11}$ $\Omega$m for spectacles and face shields.

The present invention adopts the method of shielding electro magnetic waves on the screen itself by dispersing the micro particles of electromagnetic shielding material within the transparent materials used for TVs, computers, or shielding spectacles, face shields, and screen protectors, which means that millimeters of thick material is needed for sufficient shielding against electromagnetic waves. It is also necessary to note that the materials for those screens can be made both single layered and multi-layered with more than two layers. In case of the screen being multi-layered, the electromagnetic shielding materials according to the present invention are required to be mixed in at least more than one layer of the screen.

In order to enhance the effectiveness of the shielding against UV rays, particulate phase or fibrous materials of titanium, platinum or mercury which is metal phase or alloy or compound phase for shielding UV rays need to be dispersed and mixed in the material of thick glass or synthetic resins according to the present invention.

The method of shielding the electromagnetic waves from cellular phones or cordless phones is the same as the above at screen part. While other parts except for the screen, the rear body of the phone is partly or wholly unshielded for enabling wireless communication, and the part facing human body are covered with shielding materials.

The present invention features, in the process of manufacturing the screen transparent part for TVs, computers, cellular phones and cordless phones, or in the manufacturing process of spectacles, face shields, screen protectors, in the process of mixing and melting the transparent glass or synthetic resins used for the material of the electromagnetic shielding layer for TVs, computers, cellular/cordless phones, shielding spectacles, face shields and screen protectors, mixing at least one of particle or fiber of metal kind, particle or fiber of metal kind alloys, particle or fiber of metal kind compounds, particle or fiber of ferrite or ferrate, particle or fiber of ferrite or ferrate alloys, particle or fiber of ferrite or ferrate compounds, particle or fiber of carbon, and particle or fiber of fine ceramics with the raw material of glass or synthetic resins in order for the millimeters-thick transparent part itself to become electromagnetic shielding.

The screen referred to in the present invention is in a broader range including the screen seeing-through parts so that it does not only refer to the image-forming parts such as LCD panels, PDP modules, OLED panels or the Braun tube's shadow mask, but its meaning also extends as far as the parts of transparent glass or synthetic resins set between formed images and viewers such as the screen modules or screen panels of TVs and computers.

The screen transparent part can be made single layered or multi-layered, where for the multi-layered screen, at least more than one of the layers are required that include the electromagnetic shielding material according to the present invention. The electric shielding layer and electromagnetic shielding layer can be placed at different levels.

The electromagnetic shielding material to be mixed is required to include more than one kind of ferromagnetic materials or ferrimagnetic materials having a single magnetic domain with the particle size of electromagnetic shielding material used required to be in the range between 0.2nm and 200nm, preferably between 0.2nm and 20nm. In addition, it is also required to have more than one of such conductive layers that have volume resistance no greater than $10^{10}$ $\Omega$m in use, preferably $10^8$ $\Omega$m. For spectacles or face shields usually used at a distance from electromagnetic wave generators, it is required to have volume resistance of less than $10^{11}$ $\Omega$m in order to shield or reduce harmful electromagnetic waves.

The ferromagnetic materials referred to in the present invention cover a broad range of meanings including general ferromagnetic materials, semi-ferromagnetic and ferrimagnetic materials. The fibrous materials referred to in the present invention include general fibers and web-form and nanotube-form materials.

The method for shielding the electromagnetic waves from cellular phones or cordless phones is the same as the above at the screen part, but the rear body of the phone is partly or wholly unshielded for enabling wireless communication, while the other parts except for the rear unshielding part are covered with electromagnetic shielding materials.

There are several methods for shielding electromagnetic waves according to cellular or cordless phone types.

For cellular phones, it is required to minimize the users' exposure to electromagnetic waves by shielding the front part of the phone so that the users can be protected in both calling mode and waiting mode. When it comes to two-part phones such as folder types or slide types, it is recommended to make the front body of the phone with electromagnetic shielding materials while leaving the outer antenna location part of the rear body unshielded or partially shielded in order to enable wireless communication.

For the cellular phones or cordless phones of slide types, when it comes to making the sliding part between the upper part and the lower part as well as making the exterior case, it is recommended to use ferromagnetic plates or ferromagnetic particulate-mixed plates, preferably ferrites-abundant plates.

For a variety of kinds of cordless phones or cellular phones, it is also possible to make phones of such kind that enables the electromagnetic shielding plate at the lower body to be opened in calling mode. In this case, the electromagnetic shielding plate attached to the rear body of the phone can be unfolded in calling mode manually, semi-automatically or automatically in order to shield the electromagnetic waves coming from the lower part of the phone to the user's body.

The biggest characteristic of present invention lies in shielding magnetic waves upon the transparent material, which is enabled by the principle that the micro ferromagnetic objects that have a single magnetic domain have strong magnetism approximately similar to the theoretical value of coercive force by having the direction of magnetism aligned.

This helps shield the magnetic waves in direct touch with magnetic objects as well as forming magnetic field around the micro magnetic objects, which means that the magnetic field influences the space between magnetic objects. As a result, electromagnetic waves are caught by strong magnetic fields or direct magnetic objects while visible rays pass through the space between magnetic objects, and almost the same principle is applied for semi-ferromagnetic ferrimagnetic objects, enabling its successful shielding.

By setting the size of the electromagnetic shielding material particles in consideration of the wavelength of visible rays so that visible rays can pass through the electromagnetic shielding material, the electromagnetic shielding material can both sufficiently shield electromagnetic waves and meet the particle size requirement necessary for insuring transparency and forming a single magnetic domain. In the present invention, it is recommendable to set the size of the electromagnetic shielding material particles to be no greater than is needed for having a single magnetic domain while its size should be the largest as long as it can ensure transparency.

It is also possible to use large-size particles that have multi-magnetic domains. However, differently from single magnetic domain particles which form extended magnetic fields around the particles, large-size particles of multi-magnetic domains are difficult to ensure transparency and, what is worse is that the magnetic fields only internally circulate, so their exterior magnetic field expansion is almost impossible, which results in poor shielding against magnetic waves that penetrate through the space between particles.

The present inventor researched the above principle to the present invention, and subsequently also invented a new method for shielding UV rays and X-rays according to the present invention.

Generally, magnetic particles less than 20~30nm in size start to show superparamagnetism effect. The smaller the size of particles, the bigger the superparamagnetism effect and the lesser the coercive magnetic force is so that it is recommended to use the largest possible particles that have a single magnetic domain as long as the transparency of light is ensured. However, since superparamagnetic materials have high magnetic sensitivity and magnetic fields are allowed in the present invention products, the effect of superparamagnetism can be reduced according to the strength of magnetic fields. If micro magnetic materials are atom size, it is also necessary to note that micro magnetic objects have nothing to do with superparamangetism, and that ferromagnetic objects have super-micro magnetic fields even in the atom size, still enabling shielding against electromagnetic waves.

The present invention adopts the method of shielding electromagnetic waves by dispersing and mixing electromagnetic shielding materials within millimeters-thick materials, not by the conventional method of applying a thin unit layer of coating. Accordingly, the method of shielding electromagnetic waves upon thick glass or synthetic resins enables much more use of electromagnetic shielding materials than the conventional methods as well as enables sufficient shielding against magnetic waves that could not be shielded by the conventional methods, leading to drastic improvement of the shielding efficiency than the conventional methods.

In the present invention, it is also possible to put in a separate thin conductive layer for shielding electric waves. However, even when it comes to shielding electric waves, it is much more recommendable to use the thick material itself rather than use a thin layer of coating as in the conventional method.

The conventional coating method was to form a metallic layer in the case of metallic vacuum plate coating, which leads to worsening of the transparency of light. That is why it was difficult to set the coating to be thicker than 1 , and the kind of available materials were limited, and it could not shield magnetic waves.

However, the present invention adopts the method of dispersing electromagnetic shielding materials in thick materials, where light which has the characteristic of wave can penetrate better between the dispersed electromagnetic shielding materials, which means that the thicker the transparent material, the better the effect of shielding. In addition, many kinds of materials are available for this method, and both electric waves and magnetic waves can be sufficiently shielded on this method.

In the present invention, the materials to be used for the transparent screens of TVs, computers, cellular phones or cordless phones, and the transparent materials of spectacles, face shields or screen protectors are as follows.

General or conductive glass, general or conductive synthetic resins are to be used with more than one of particle or fiber of metal kind, particle or fiber of metal kind alloys, particle or fiber of metal kind compounds, particle or fiber of ferrite or ferrate, particle or fiber of ferrite or ferrate alloys, particle or fiber of ferrite or ferrate compounds, particle or fiber of carbon, and particle or fiber of fine ceramics as electromagnetic shielding materials to be mixed with the materials of the above screens, spectacles, face shields, screen protectors.

Among the materials mentioned above, ferrites and ferrates are also included in metals. But due to their superior magnetic wave shielding effect, they are separately described.

In order to improve the electric conductivity, highly conductive kind metals of a variety of ferrites or ferrates can be used, or the amount of highly conductive electromagnetic materials such as iron nano particles can be increased, or an additional layer of conductive coating can be added. In order to shield UV rays more sufficiently, it is preferable to include titanium in the electromagnetic shielding materials to be used.

Electromagnetic waves can be divided into electric waves and magnetic waves, where electric waves can be easily shielded by conductive materials but the shielding against magnetic waves has nothing to do with conduction. The present invention enables shielding against both electric waves and magnetic waves by using the materials that have conduction or magnetism. It is also necessary to note that the materials that have both conduction and magnetism can be used to shield both electric waves and magnetic waves simultaneously. The materials generally known so far to have the best effect for shielding magnetic waves are ferrates and ferrites.

Such a method can be adopted that adds an electromagnetic shielding function to the screen materials for TVs, computers, cellular phones, or cordless phones with electromagnetic shielding coating or antistatic coating addition, or other coatings against UV rays or near-infrared rays are also possible for addition. For transparent glass, visible rays pass through it easily, but UV rays or far-infrared rays bring about the frequency resonance with the inherent frequency of glass. This consumes more energy, which leads to higher shielding rates against UV rays or far-infrared rays than visible rays. Accordingly, passing only visible rays selectively is to shield magnetic waves in the frequency band below the wavelength of infrared rays according to the present invention.

The shielding effect against UV rays can be enhanced by adding electromagnetic shielding materials according to the present invention. However, in order to enhance the shielding effect against UV rays much more, it is recommended to use the metals, particulate phase or fibrous materials of highly UV ray-shielding metals such as platinum, titanium or mercury by way of the exterior coating method or inside-screen mix method. Among the materials above, it is recommended to use titanium because platinum is expensive while mercury is toxic. The exterior coating method is a conventional method already known, and the inside-screen mix method is to mix the metals, particulate phase materials of platinum or titanium with other metals according to the size of diameter introduced in the present invention. It is also necessary to note that, even in this case, the conventional metallic exterior coating method also has the problem of limited transparency as in other electromagnetic shielding materials so that it is much more recommendable to adopt the dispersion mix method according to the present invention.

Among other conventional ways available are to apply a coating of transparent UV ray-shielding synthetic resins on the exterior screen, or to melt and mix UV ray-shielding synthetic resins with other materials in the process of manufacturing the screen, both of which are already known methods.

The present invention enables the shielding against electromagnetic waves on the transparent screens and screen protectors. The shielding for the case part is much easier in that it does not have transparent part for shielding against electromagnetic waves, so that for complete shielding, it is most recommendable to make both the screen part and case part in the electromagnetic shielding way, and to use a system of earthing for complete shielding of TV's and computer's electromagnetic waves. That way, products that enable shielding electromagnetic waves from all direction can be manufactured.

The cases of TVs, computers, cellular phones, and cordless phones can be made from metals even though synthetic resins are used more for them. Thick materials can be used for the above cases so that they can be made in multiple layers comprising electromagnetic shielding layers and non-electromagnetic shielding layers. However, for cellular phones or cordless phones, it is required to shield electromagnetic waves on a thin case so that it is recommendable to make the case or keypad electromagnetic shielding with maximum use of case. For electromagnetic shielding materials of the case, all the electromagnetic shielding materials according to the present invention can be used and, for shielding electromagnetic waves on the case or keypad, the problem of transparency does not matter, it allows the size of particles to be set larger so that such a method can be considered that shields magnetic waves using the ferromagnetic particulate phase, fibrous or plate materials that have multiple magnetic domains. However, using single magnetic domain particles is more recommended in case of not using ferromagnetic plate, when the efficiency, product weight, the problem of generation of magnetism or problem of case molding is considered.

When it comes to forming multiple magnetic domains, such ways can be considered in order to enhance the shielding effect of magnetic waves that use electromagnetic shielding materials as permanently magnetic materials or, for temporarily magnetic materials, apply magnetism in the process of mixing and melting and align magnetic directions.

However, the method of dispersing single magnetic domain particles is more practical to use than making the whole material permanently magnetic.

The most recommendable way in the present invention is to disperse and mix the electromagnetic shielding materials of the particle size which is less than a single magnetic domain that has strong magnetic field, so that each single magnetic domain can shield magnetic fields individually while not making the whole product magnetic.

The critical particle size necessary for forming a single magnetic domain is different one magnetic material another.

The critical particle size necessary for forming a single magnetic domain is 40nm for iron, 60nm for cobalt, 1 for barium ferrites (BaO·6Fe2O$_3$), 200nm for neodymium boron magnet (Nd$_2$Fe$_{14}$B), 1.3um for samarium cobalt magnet (SmCo$_5$).

For the case part or keypad that is not limited by the problem of transparency, the most efficient size of electromagnetic shielding material particles is the critical particle size (the largest particle size for a single magnetic domain) that has a single magnetic domain.

Electromagnetic shielding materials can be devided into conductive materials and non-conductive materials. However, using conductive materials for the exterior case of TVs and monitors runs the risk of electric shock so that, if possible, conductive materials need to be put inside the case for safety.

There are a variety of ways for earthing, the most efficient of which is to make a metal terminal on the conductive shielding material part and connect an earthing line from the metal terminal to earth to the exterior ground. When it is difficult to earth to the exterior ground, such a method can be considered that brings about the corona discharge putting strands of metallic fine threads on the earthing line in a safe place to remove electrification. When it comes to shielding the electromagnetic waves for screens and screen protectors, the screens or screen protectors are also recommended to be equipped with their own system for earthing. Earthing can be done both by linking to the earthing line of electric power that is connected to the main body and by exposing the earthing line and earth electrode to the exterior.

The present invention can be currently applied to the TVs and monitors of the Braun tube type, PDP type, LCD type and, in the future can be applied to more various types of TVs and monitors such as OLED types, 3D types, FED types, flexible types etc., all types are possible.

The level of the shielding against electromagnetic wave varies according to a variety of factors such as the kinds, the sizes, thickness, the amount of electromagnetic shielding materials contained, shielding methods, conductivity and whether magnetic fields will be allowed or not in the case of mixing and melting magnetic shielding materials and cooling under the temperature of Curie. It is also necessary to note that the more the amount of electric shielding materials to be used or the thicker the electric shielding layer, the higher the shielding effect.

The resistance of an object with volume can be described as the proportional expression, R L/A.

Assuming the inherent volume resistance of an object to be ρ, it can be expressed as R = ρ·L/A.

Here, the volume resistance ρ = R · A / L, so that the unit is in Ω·m or Ω·cm.

(Here, R represents the resistance of an object, ρ represents the inherent volume resistance of an object, L represents the length of a specimen and A represents the sectional area of the specimen. The unit of R is in Ω·m or Ω·cm, the unit of L is in m or cm, and the unit of A is measured in or ).

Korea Occupational Safety & Health Agency standard KOSHA CODE E-34-2007 regulates that the standard of conduction should be no greater than $10^8$ Ω·m, and the standard of semi-conduction is $10^8$ Ω·m~$10^{10}$ Ω·m. Generally the volume resistance of nonconductor is $10^{12}$ Ω·m~$10^{15}$ Ω·m.

The electric shielding effect cannot be expected from the nonconductor whose volume resistance is higher than $10^{12}$ Ω·m. That is, in the present invention, the standard of volume resistance is set to be less than $10^{10}$ Ω·m, the standard of semi-conduction when electromagnetic waves are discharge with the power of computers or TVs on, so that it could have a semi-conductive layer or conductive layer. It is also necessary to note that, for more successful electromagnetic shielding effect, it is more recommendable to set the volume resistance to be less than $10^8$ Ω·m, which is the standard of conduction, rather than $10^{10}$ Ω·m, which is the minimum standard of semi-conduction. The more conductive an object, the higher the electric shielding effect is.

The volume resistance necessary for electromagnetic shielding spectacles or face shields in using a computer or watching a TV can be simply calculated as follows.

Computer monitors the present invention is directed for generally have the field intensity of about 130~150 V/M at 30~50cm of a monitor and, almost the same field intensity even for a TV. In general, an object that aims to remove the strong electrostatic charge of about 10,000V~15,000V is required to have volume resistance no greater than $10^8$ Ω·m for successful removal of electrostatic charge.

When the quantity of electric charge is great, the volume resistance of an object is required to be low for swift removal of electrostatic charge, while when the quantity of electrostatic charge is little, successful removal of electricity is possible even with greater volume resistance.

This can be calculated as follows.

```
150V ÷ 15000V = 0.01 and 130V ÷ 15000V = 0.0087.
```

Based on the above calculations, $10^8$ Ω·m ÷ 0.01 = $10^{10}$ Ω·m and $10^8$ Ω·m ÷ 0.0087 = 1.15 $\times 10^{10}$ Ω·m so that the conduction level necessary for successful removal of electricity at the field intensity of 130~150 V/M can be calculated as $10^{10}$Ω·m~1.15$\times 10^{10}$ Ω·m.

This is almost the same value as $10^{10}$ Ω·m, the standard value of semi-conduction regulated in KOSHA CODE E-34-2007, and this value also successfully falls in between $10^{10}\Omega\cdot m \sim 10^{11}\Omega\cdot m$, the value range meeting the standard to be no greater than $10^{11}\Omega\cdot m$ set in the present invention for shielding spectacles and face shields.

Assuming that, due to the advance of electromagnetic-wave controlling techniques in the future, the strength of electromagnetic waves from monitors or TVs can be reduced to 15V/M at a user's distance, 15V ÷ 15000V = 0.001, which means that the electromagnetic shielding volume resistance calculated in the same method necessary for minimal electricity removal is less than the $10^{11}\Omega\cdot m$ calculated by $10^8 \, \Omega\cdot m \div 0.001 = 10^{11}\Omega\cdot m$ so that it meets the standard to be under $10^{11} \, \Omega\cdot m$, the standard of specific resistance of the present invention for shielding spectacles or face shields.

It is necessary to note that when the micro electromagnetic shielding material particles of great coercive force such as iron or ferrites are dispersed and mixed with other materials according to the present invention, magnetic moments between particles could resist to each other based on the distance between particles and the size of particles, resulting in neighboring magnetic moments being aligned in the contrary direction. This case is similar to GMR (giant magnetoresistance), a huge magnetic resistant effect, so that the conduction or whole magnetism can be reduced unusually compared to otherwise. In this case, the strength of conduction or magnetism can be adjusted through a variety of ways such as adjustment of sizes, the distances of particles or adjustment of the dispersion of particle sizes, or mixing with other materials such as fibers, or the allowance of exterior magnetic fields in the process of material manufacturing.

Ferrites known to be highly electromagnetic shielding has more than three times as great volume resistance as general metallic magnetic objects with the value of volume resistance of ferrites varying between $10^0 \, \Omega\cdot m$ and $10^{10} \, \Omega\cdot m$ according to the kind of ferrites. Considering these values, it is difficult to give sufficient conduction when using the ferrites that have highly specific resistance value. When using only ferrites or ferrates as the shielding materials without use of any other conductive materials, it is recommendable to use such ferrites or ferrates that have both great magnetism and great conduction for the removal of electric waves.

The most preferred embodiment of the present invention is to disperse and mix nano particles of ferrites or ferrates within the transparent glass or synthetic resins that aim to shield electromagnetic waves, with the volume resistance of the object to be $10^5 \, \Omega\cdot m \sim 10^8 \, \Omega\cdot m$ in use, and with the size of the nano particles to be 0.2 -20 so that it can sufficiently shield all other harmful electromagnetic waves except for visible rays.

Another preferred embodiment of the present invention is to disperse and mix nano particles of ferrites or ferrates with titanium particles within the transparent glass or synthetic resins that aim to shield electromagnetic waves with the volume resistance of the object to be $10^5 \, \Omega\cdot m \sim 10^8 \, \Omega\cdot m$ in use, and with the size of the nano particles to be 0.2 -20 so that it can sufficiently shield all other harmful electromagnetic waves except for visible rays.

In order to give conduction to non-conductive glass, such methods can be considered that mix conductive electromagnetic shielding materials like the metals mentioned above with glass, or apply a conductive coating, with the value of volume resistance of the object to be under $10^{10} \, \Omega\cdot m$ in use, preferably $10^8 \, \Omega\cdot m$.

In order to give conduction to non-conductive synthetic resins, such methods can be considered that mix conductive electromagnetic shielding materials like conductive polymers or metals with synthetic resins, or use the synthetic resins that have their own conduction, or apply a conductive coating. Among the synthetic resins that have their own conduction are such polymers as polypyrroles, polyanilines, polyacetylenes, polythiophenes, liquid polyesters, polyvinyl terosens, polyvinyl acetylenes, polyacrylonitriles, etc. These conductive synthetic resins can be used on their own, and more than one of them can be mixed. In addition, they can be mixed with other non-conductive synthetic resins to make conductive or semi-conductive synthetic resins.

In order to sufficiently shield the magnetic waves which are very harmful to human bodies, the products according to the present invention need to mix a sufficient amount of highly magnetic shielding materials rather than only mix conductive materials of highly electric shielding effect, so it is recommendable to mix ferrites or ferrates which consist of magnetic iron oxides that have highly magnetic shielding effect. Among other recommendable materials that can be applied to the present invention for shielding magnetic waves aside from ferrites or ferrates are such as highly magnetic iron, cobalt, nickel, and highly magnetic alloys or compounds made from them. In addition, highly magnetic materials such as the alloys of manganese and bismuth, despite not having high magnetism or semi-magnetism in itself, the permanent magnetic alloys of silver, manganese and aluminum or magnetic fine ceramics can be used.

Recently, a new method has been devised that mixes iron with rare metals like neodymium and boron to make a strong permanent magnet such as neodymium magnet. The mix of rare metals like this works to fix iron atoms by preventing iron atoms from being converted to magnetic domains, giving them strong permanent magnetism under the Curie point.

Every wavelength can be expressed as the characteristics of particles, so electric waves have the characteristics of matter wave with electric charge, and they are caught by conductive materials and removed as the flow of electric current.

It is also necessary to note that electric particles go through magnetic fields, change their running direction under the existence of magnetic fields, and removed like the electric charge of the solar winds removed with aurora by the magnetic field of the earth. This tends to be stronger as the object is more magnetic, and as the strength of electromagnetic waves is weaker.

According to the present invention, magnetic waves can also be regarded as a matter wave which is a flow of magnetic particles. In addition, magnetic electric shielding materials have a magnetic field between the N pole and S pole so that it can catch and shield magnetic flows of particles with the magnetic field, which means that even magnetic particles around the electromagnetic fields can be caught and shielded. For the case part, if the whole case is made with magnetic shielding materials without a gap, the case can directly shield electromagnetic waves.

Electrons, an elementary particle, are also divided into the N pole and S pole, making the case that the particles that form the wavelength of a magnetic wave may be a much smaller elementary particle than even the electrons, and furthermore may be one of the ultimate particles that form the physical world.

Without sufficient magnetism, even conductive metals cannot shield magnetic waves because there is no sufficient magnetic field to catch magnetic waves. Accordingly, the present invention aims to shield magnetic waves through magnetic shielding materials that have permanent or temporary magnetism, with strong magnetism or ferrimagnetism. Ferrites and ferrates are one of the best and cheapest materials known so far for magnetic shielding effects so that they are the representative materials to be used for the present invention.

Among the general manufacturing process of inputting, melting, mixing, forming and processing for the glass or synthetic resins of the products, the manufacturing process where electromagnetic shielding materials - such as metal kind or ferrite kind, etc. - are put in according to the present invention is between the raw material inputting process and the melting, or mixing process.

In order to improve the electric conductivity of the materials for the present invention, it is considered to put in a great amount of conductive metallic powder or to mix in fibrous electromagnetic shielding materials or transparent conductive materials that can be resolved or melted into glass or synthetic resins. For transparent materials, the conductivity of glass can be improved by increasing the amount of soda to be put in or by putting in melted metal. For synthetic resins, conductivity can be increased by using conductive polymers such as polypyrroles, polyanilines, etc.

For metallic nano particles or fibrous materials used for the present invention, the smaller their particles are in size, the better in transparency, and also better conductivity due to the distance between their particles becoming shorter. Accordingly, in order to improve transparency and conductivity, it is more useful to use particulate phase or fibrous materials of small sizes. However, it has to be considered that in such cases, the electromagnetic shielding effect can be reduced due to superparamagnetism. Using of fibrous shielding materials enables direct electric connection between electric shielding materials, leading to better conductivity.

The method of the present invention to disperse micro electromagnetic shielding particles or fibers within thick materials enables containing much more electromagnetic shielding materials per unit penetration thickness than conventional methods, so that the thicker the screen, the more efficient for shielding electromagnetic waves it is, and the harmful electromagnetic waves are shielded by plentiful electromagnetic shielding materials dispersed within the screens or cases. Electric waves are shielded by conductive materials and magnetic waves are shielded by magnetic materials. And, the smaller the size of the particles of the electromagnetic shielding material to be used, the better transparency they can maintain due to a variety of factors such as the wave nature, the amplitude and diffraction effects of visible rays, the transparency of the glass, and the characteristics of the visible ray photon that hardly influenced by conductivity or magnetic material. Because of above factors, visible rays are able to pass the see-through part of screen without blocking by fine shielding material.

Although the wavelength of visible rays is hardly shielded by electromagnetic shielding materials within the electromagnetic shielding layer, electromagnetic waves in other wavelength ranges can be sufficiently shielded.

For UV rays or X-rays, though their absorption rates on transparent materials are different from each other, they have very short wavelengths so that they are well shielded by electromagnetic shielding materials. For the magnetic fields of long-wavelength above infrared rays, they have very weak energy of magnetic wavelength so that they are well shielded by the electromagnetic shielding materials and magnetic fields of single magnetic domains that have strong coercive power.

Comparing the wavelength and energy of 300MHz~30GHz band which is very harmful microwaves due to its strong heating effect, with those of 500 which is the yellow wavelength of visible rays which is the standard color, the frequency can be calculated as follows assuming that the speed of light is 300,000km/sec, which is $3 \times 10^{17}$ /sec.

The frequency of yellow light $\sqrt{}$ is $3 \times 10^{17}$ /s $\div$ 500 = $6 \times 10^{14}$ Hz.

The frequency of a 300MHz electric wave is $3 \times 10^8$ Hz and the frequency of a 30GHz electric wave is $3 \times 10^{10}$ Hz.

Every material and wave has both-sidedness so that according to the De Broglie's matter wave concept, energy E = h$\sqrt{}$ (here the parameter 'h' means Planck constant, which is $6.63 \times 10^{-34}$ J·s, and $\sqrt{}$ means a frequency).

Since energy is directly proportional to the frequency, the energy of a 500 light is E=$6.63 \times 10^{-34}$ J·s$\times 6 \times 10^{14}$ Hz, the energy of a 300Mhz electromagnetic wave is E=$6.63 \times 10^{-34}$J·s $\times 3 \times 10^8$ Hz, and the energy of a 30Ghz electromagnetic wave is E=$6.63 \times 10^{-34}$ J·s$\times 3 \times 10^{10}$ Hz.

As a result, the energy of a 500 visible ray is two million times stronger than the energy of a 300Mhz electromagnetic wave as calculated by $6 \times 10^{14}$ Hz $\div$ $3 \times 10^8$ Hz = 2,000,000 and is twenty thousand stronger than the energy of a 30GHz electromagnetic wave as calculated by $6\times10^{14}$ Hz $\div$ $3\times10^{10}$ Hz = 20,000.

The reason microwaves are more harmful to humans even though the energy of visible rays is much stronger as shown above is because the strongest wavelengths of the spectrum of the sun that can reach the surface of the earth are about 500 range of visible rays and almost all the creatures on the earth have grown accustomed to the rays so that they can see visible rays and are not harmed by visible rays. However, almost all the other wavelengths aside from visible rays are blocked by the layer of the atmosphere and geomagnetic fields so that such rays can be very harmful to ground creatures because they are not accustomed to these rays. However, the present invention can enable sufficient shielding against all the other bands of electromagnetic waves except for visible rays by using the strong magnetic field of micro particles, with the relation of light transparency and electromagnetic wave wavelengths according to the size of shielding materials.

The most frequently used wavelengths for cellular phones are 800MHz and 2GHz bands.

Compared to the yellow visible ray that has 500 of wavelength, the energy of a 800Mhz wavelength is just 1/750,000 times than the energy of a yellow ray, as calculated by $6\times10^{14}$ Hz $\div$ $8\times10^8$ Hz = 750,000, and the energy of a 2GHz wavelength is just 1/300,000 times than the energy of a yellow ray, as calculated by $6\times10^{14}$ Hz $\div$ $2\times10^9$ Hz = 300,000.

As the above comparison shows that the energy of the electromagnetic photons from cellular phones are 1/300,000~ 1/750,000 times that those of visible rays, the 800Mhz electromagnetic wave of cellular phones can be 750,000 times better shielded and the 2GHz electromagnetic wave can be 300,000 times better shielded than yellow visible rays, so that they can be more easily shielded by the electromagnetic shielding materials that have strong single magnetic domain and magnetic field according to the present invention.

On the same principle, it can be shown that the electromagnetic waves of the very low frequency 60Hz from home-use appliances can be $1\times10^{13}$ times better shielded than yellow visible rays, as calculated by $6\times10^{14}$ Hz $\div$ 60 Hz = $1\times10^{13}$.

In addition, among a variety of bands of electromagnetic waves from TVs or computers, the energy of an electromagnetic wave of 0.1MHz~1MHz is 1/ $(6\times10^9)$ times than the energy of a yellow visible ray, as calculated by $6\times10^{14}$ Hz $\div$ $1\times10^5$ Hz = $6\times10^9$, and the energy of an electromagnetic wave of 1MHz is 1/$(6\times10^8)$ times than the energy of a yellow visible ray, as calculated by $6\times10^{14}$ Hz $\div$ $1\times10^6$ Hz = $6\times10^8$, so that the electromagnetic waves of 0.41MHz~1MHz can be $6\times10^9$~ $6\times10^8$ times better shielded than yellow visible rays.

Harmful electromagnetic waves, which are the representative object of removal in the present invention, have the energy as small as 1/$(3\times10^5)$~1/$(1\times10^{13})$ times than the energy of yellow visible rays according to the above calculation, so that they can also be easily shielded by the present invention.

The present invention found out the appropriate size for electromagnetic shielding materials not only in consideration of the size of the particles which have a single magnetic domain but also the size of particles that visible rays can penetrate as long as transparency is ensured.

The following is the research statement on how to find out the appropriate size of the electromagnetic shielding materials necessary for ensuring the transparency of light.

Generally the size of the material to shield a wave should be greater than the amplitude of the wave, and considering horizon, if the height of the material is lower than the height of the wave, the wave flows over the shielding material. The shorter the height of the shielding material, the more easily the wave overcomes the shielding material. If the height of the shielding material is taller than the effective amplitude of the wave, it is difficult to pass through the shielding material other than by diffraction. Applying the above principle, the present invention decided on its standard of the particle diameter size of particulate phase or fibrous materials for electromagnetic shielding, based on the sine wave, the most representative wavelength of electromagnetic waves. The standard of the size for particulate phase materials in the present invention is measured in diameter assuming a sphere form, and the standard of the size for net-form or nanotube-form fibrous materials is measured in diameter. When the particular matters are not a sphere form but an irregular form, the average of the major axis and the minor axis can be used, but it is more desirable that the minor axis prefer as the standard.

Even in consideration of the wave of light, the present invention, differently from conventional coating methods, features dispersing electromagnetic shielding particulate phase or fibrous materials within transparent screens, which enables visible rays to penetrate through between electromagnetic shielding particles easily because there are a lot of empty spaces between particles so that even though much more electromagnetic shielding materials are used than the conventional coating method, visible rays can penetrate through between electromagnetic shielding particles. In the meantime, harmful electric waves and magnetic waves that have long wavelengths of weak energy are sufficiently shielded electromagnetically and short wavelengths above UV ray are shielded by the glass or synthetic resins or shielding material itself, so that only visible rays pass.

Generally visible rays have wavelengths of 380 ~ 720, and the amplitude varies according to the brightness of light. However, light is a transverse wave so that, for the sine wave which is the most representative wavelength, the effective plus amplitude value of the amount of the wave of light is 95 nm-190 nm, as 1/4 times of the wavelength. Of course total light amplitude is 190 -360 . It is also necessary to note that because the wavelength of visible rays can be measured up to 400 -800 according to measurers, in that case the effective value of the amplitude of light should be 200 -400 when the minus field is included.

In case of considering the amplitude of light being 95 -100 , which is the effective plus amplitude of the shortest wavelength of the above waves, light can be scattered or blocked if the size of shielding particles is greater than 100 . The limit value of the wavelength of the violet rays that have the shortest wavelength of visible rays is 380 so that, for the transverse wave of a sine wave, light which has a short wavelength of 380~400 is quite blocked by electromagnetic shielding particles when the size of electromagnetic shielding particles is greater than 95 -100 . When the size of electromagnetic shielding particles is greater than 200 , light is mostly blocked, leading to worsening of the quality of the vision on the screens of TVs or computers due to scattering and blocking of light.

As described above, particle sizes of about 100 -200 cause significant light scattering and shielding of visible rays so that the upper limit of the size of the electromagnetic shielding materials for the present invention is set to be 200 based on the total effective amplitude of the shortest wavelength of visible rays. For much better transparency, it is recommended to use electromagnetic shielding materials of smaller sizes for all products.

Based on 200 , which is the standard value to block short-wavelength visible rays, the unit particle size necessary for light penetration rate of 99% can be calculated as follows.

The cross section of an object with the diameter of 200 is $200 \times 200 = 40000^2$, and the cross section of an object with the diameter of 20 is $20 \times 20 = 400^2$, which is 1% of $40000^2$.

This is about 1% of area with the penetration rate of light being 99% so that, assuming the light penetration rate of 99%, which is 100 times as the safety rate, the recommendable upper limit for electromagnetic shielding materials is 20 . It is recommended to use electromagnetic shielding materials smaller than this size. The penetration rate of light increases as the diameter is smaller.

For iron which is the most representative ferromagnetic material, the size necessary for forming a single magnetic domain is no greater than 40 , so that when iron is used as an electromagnetic shielding material, it is recommendable to set the largest size to be no greater than 40 .

Considering the wavelengths of visible rays, use of the particles 20~200 in size can amplify the shielding effect against the short wavelengths of visible rays so that it is likely to cause red shift as well as light scattering. However, the red shift effect can also be decreased by using particles less than 20 where more than 99% of violet rays can pass.

As a result, considering the penetration rate of light and red shift effect, the particle size is recommended to be less than 20 .

The shielding area of a shielding particle of 10 size is just 1/4 of that of a 20 size particle so that, based on the above simple calculation, it can be shown that only 0.25% of light is blocked compared to the shielding materials of 200 , which means that even for violet rays, 99.75% of light can penetrate, light penetration better than 20 particle.

In the present invention, the lower limit value of electromagnetic shielding materials, which is related with the size of atoms, is also considered to shield X-rays or UV rays harmful to human bodies with their high energy levels.

Generally, the wavelength of UV rays is about 10 -380 and that of X-rays is about 0.001 ~10 . Some band of UV ray and X-ray wavelengths are overlapped and X-rays generally used have about 0.1 of wavelength.

Lead glass is generally used for shielding against X-rays so that, for the screens of TVs or computers that give off a lot of X-rays, the present invention can also use lead oxide along with the electromagnetic shielding materials.

Iron atoms, which are one of the most important magnetic shielding particles for particulate phase electromagnetic shielding materials to be used in the present invention, have about 0.28 diameter. The iron atoms in the ionic state is about 0.12-0.21 in diameter. These sizes are greater than 0.1 , the size of the band that is mostly used for X-ray band, so that, just considering a wavelength, X-rays that have these wavelengths can be fairly shielded.

For the size of electromagnetic shielding particulate phase or fibrous materials, it is recommendable to use those that can shield both electric waves and magnetic waves. In this regard, iron has the strongest magnetism on the atom base so that it is an appropriate material for shielding magnetic waves as well as electric waves with its conduction. In addition, iron is cheaper than other materials so that, based on the diameter of iron atom, the present invention sets 0.2 to be the lower limit size of electromagnetic shielding materials.

X-rays have high straightforwardness and low diffraction due to its short wavelengths so that, for direct shielding, the larger the size of the shielding materials, the more efficient for shielding.

UV rays have about 10 of wavelength, that falls on the lower range of X-ray wavelengths and the higher range of UV rays. Considering that the size of shielding particles for UV rays is 2.5 based on the above calculation, the size of the particulate phase or fibrous materials for shielding UV rays is recommended to be greater than 2.5 with a lot of shielding materials of these sizes to be contained preferably. However, iron atoms of 0.2~2.5 in diameter can also shield electromagnetic waves so that these micro shielding particles of less than 2.5 may be mixed with other particles of greater than 2.5 .

Most of the UV rays that have 80 of wavelength can be shielded as calculated by $20 \times 4 = 80$ just based on the effective value, so that UV rays and X rays that have less than 80 of wavelengths are easily shielded in case of using 20nm diameter shielding materials. Although the present invention has much better shielding effects than other inventions even for UV rays of greater than 80 because the present invention uses particulate phase matters, highly UV ray-shielding materials can be added for much more complete shielding effect.

Among the conventional methods for shielding UV rays are such as metallic coating of platinum, titanium or mercury upon the exterior of glass, and attachment of UV ray shielding films, or coating of UV ray shielding synthetic resins. Aside from the coating methods that can be used for synthetic resins as the above, there are other ways known that enable directly absorbing UV rays upon its own synthetic resins such as using UV ray-absorptive synthetic resins, or melting and mixing UV ray-absorptive synthetic resins in the process of melting or mixing.

In addition to the UV ray shielding methods mentioned above, the present invention enables blocking of UV rays by directly mixing the metallic nano particulate phase or fibrous materials according to the present invention within glass or synthetic resins to be used for screens or screen protectors. Though the electromagnetic shielding metals according to the present invention have their own UV ray-shielding effect, such a way can be considered that mixes highly UV ray-shielding titanium, its alloys or nano particulate phase or fibrous materials of its compounds in order to enhance UV ray-shielding effects. The size of titanium atom is about 0.28 in diameter while the diameter of titanium ion is about 0.11~0.2 .

For blocking near-infrared rays, such a method is known that applies a coating of high polymers or pigment.

If these kinds of methods that shield UV rays or near-infrared rays are used along with the electromagnetic shielding method according to the present invention, almost all the electromagnetic waves such as X-rays, UV rays and all electromagnetic waves under the wavelength of infrared rays can be shielded leaving only visible rays to pass.

Even though the mixed layer of other materials such as titanium is recommended to be mixed with the electromagnetic shielding materials according to the present invention for enhancing the effectiveness of UV ray shielding, such a way can be considered that applies an additional layer only for shielding UV rays.

For the amount of electromagnetic shielding materials to be used, it needs to ensure much transparency. So it is recommended to set the amount of electromagnetic shielding materials so that at least greater than 50% of transparency can be ensured. Even though the transparency level can be reduced to 20~50%, the less transparent, the more inconvenient it is, to use the products according to the present invention.

For non-conductive materials such as glass or synthetic resins, the conductivity of the materials is determined by the kind, form, and amount of the electromagnetic shielding material to be mixed with. For mixing particulate phase electromagnetic shielding materials of the same amount, the larger the size of particles of the electromagnetic shielding materials, the worse the penetration of light, and also worse conductivity because the distance between electromagnetic shielding particles becomes wider. On the other hand, when the size of electromagnetic shielding materials to be mixed with is small even if the amount is same, the penetration of light increases, and the distance between each particle gets closer so that conductivity can be improved due to the jumping effect related with quantum mechanical tunnel effects of electrons. Of course the fibrous materials can be directly electrically connected.

Fine ceramics are such as zirconium oxides, aluminum oxides, titanium oxides, silicon carbides, cobalt compounds, iron compounds, zinc compounds, etc., all of which have conductivity or magnetism. Fine ceramics are also referred to as new ceramics compared to the kaolin of the past used for porcelains.

The present invention uses micro nano particles so that sufficient care is needed for safety. While some materials such as oxidized or inactive nano materials are relatively safe to handle, highly oxidizing materials such as pure metals made up of iron atoms, if handled in the dust form, can react with the oxygen in the air to cause dust explosion. Therefore, safety methods need to be taken in handling these materials, and such a way can be considered that applies a layer of coating of other materials on electromagnetic shielding materials before handling in order to enhance safety or electromagnetic shielding effects. Furthermore, micro nano particles can get into human's respiratory organs and cause chronic or acute diseases, and can pass through human's skin so that safety methods need to be taken in terms of health.

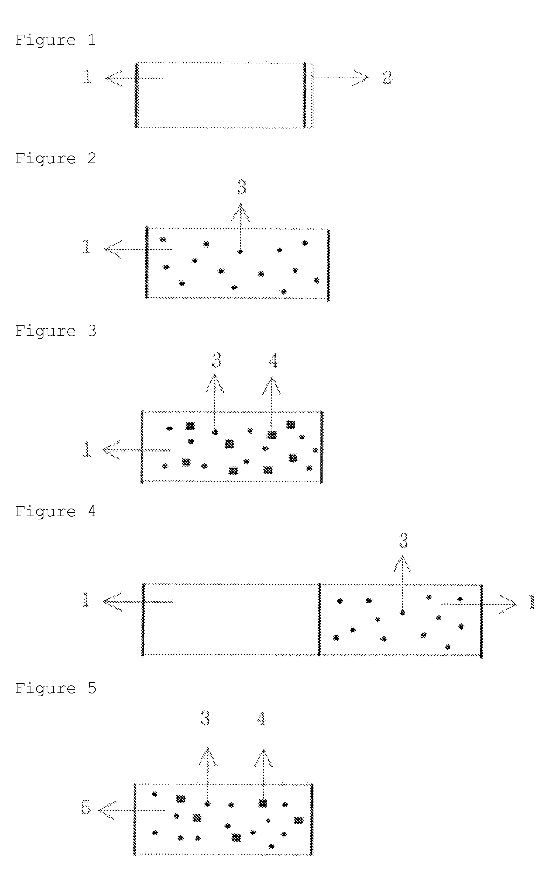

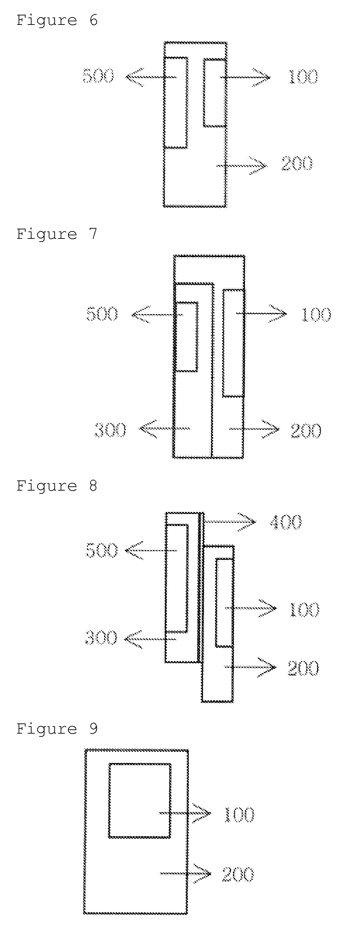

Some figures are attached below for more detailed explanation of the present invention. FIGS. 2, 3, 4 and 5 illustrate an example of practical application of the electromagnetic shielding screens according to the present invention and FIGS. 6, 7, 8 and 9 illustrate embodiments of cellular phones and cordless phones. The form or shape or matter is changeable within the scope of the present invention.

In the figures, transparent glass and transparent synthetic resins can be shifted each other.

FIG. 1 is a cross-sectional view of an exemplary transparent screen with conventional conductive coating, which is made up of conductive coating 2 on a transparent screen 1.

FIG. 2 is a cross-sectional view of an exemplary thick layer that includes electromagnetic shielding materials where nano particles are dispersed according to the present invention. Referring to FIG. 2, nano powder of ferrite compounds 3 for shielding electromagnetic waves is contained in transparent glass 1.

FIG. 3 is a cross-sectional view of an exemplary thick layer that includes electromagnetic shielding materials where nano particles are dispersed according to the present invention. Referring to FIG. 3, electromagnetic shielding ferrite compounds 3 and nano powder of titanium 4 are contained in the transparent glass 1.

FIG. 4 is a cross-sectional view of exemplary transparent glass 1 to which a thick electromagnetic shielding layer is attached according to the present invention. Referring to FIG. 4, the nano powder of electromagnetic shielding ferrite compounds 3 is contained in the glass 1.

FIG. 5 is a cross-sectional view of an exemplary thick layer that includes electromagnetic shielding materials according to the present invention where nano particles are dispersed in a screen protector. Referring to FIG. 5, the nano powder of electric shielding ferrites 3 and nano powder of magnetic shielding titanium 4 are contained in the conductive and transparent material 5 for the screen protector.

FIG. 6 is a side view of an exemplary bar-type cellular or cordless phone. Referring to FIG. 6, the main body 200 and a screen transparent part 500 of the cellular or cordless phone are made using electromagnetic shielding materials, while an exterior cover of an antenna part 100 does not contain electromagnetic shielding materials, enabling transmission of electromagnetic waves for communication.

FIG. 7 is a side view of an exemplary folder-type cellular or cordless phone. Referring to FIG. 7, the front folder 300, the screen 500 and the main body 200 use electromagnetic shielding materials while the rear body 100 does not use electromagnetic shielding materials for the antenna to be set up.

FIG. 8 is a side view of an exemplary cellular or cordless phone of sliding type. Referring to FIG. 8, electromagnetic shielding materials are used for the screen 500, the front part 300 and the main body part 200 where the keypad of the rear body is set. However, electromagnetic shielding materials are not used for the antenna part 100 on the rear body, enabling the penetration of electromagnetic waves for communication. Specifically for a sliding part 400, it is recommended to use plates of ferromagnetic materials such as ferrites or ferrates.

FIG. 9 is a plan view of a rear part of one of cordless phones or cellular phones including bar types, folder types and sliding types. Here, the cover of electromagnetic shielding layer 200 occupies the circumference of the rear body and the electromagnetic penetrating layer 100 having a transmission/reception part occupies the upper center part of the rear body. It is also possible to enlarge the electromagnetic penetrating layer 100 so that it can equal to the electromagnetic shielding layer 200. However, the electromagnetic penetrating layer 100 is recommended to be made small. Especially for sliding types, it is recommended for the size of electromagnetic penetrating layer 100 to be completely covered by the front screen.

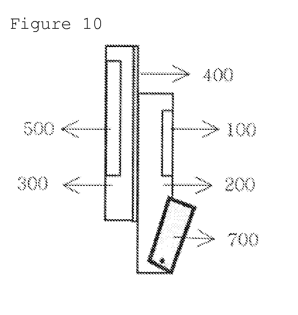

FIG. 10 is a side view of one of a variety of cordless phones or cellular phones where an electromagnetic shielding part 700 on the lower part is opened in calling mode. Referring to FIG. 10, the electromagnetic shielding part 700 usually attached to the rear body 200 of the phone is opened manually, automatically or semi-automatically in calling mode in order to shield electromagnetic waves toward user's body.

Advantageous Effects

The present invention can shield electromagnetic waves on the millimeters-thick transparent parts of TVs, computers, cordless phones, spectacles, face shields, and screen protectors so that the electromagnetic shielding effects are considered superior to the conventional method using a micrometer-thin coating. In addition, the present invention can also enable shielding against magnetic waves that, despite being much more harmful to the human body than electric waves, cannot be shielded by conventional methods. In this regard, the present invention can be considered a very ideal invention that can shield all the harmful electromagnetic waves except for visible rays.

Furthermore, the present invention helps to sufficiently reduce the threat of electromagnetic waves on cellular phones or cordless phones that people have been helplessly exposed to.

The present invention is very helpful for health in that it can prevent a variety of diseases caused by TVs, computers, cellular phones or cordless phones such as eye diseases, dizziness, abortions, deformed child delivery, ADHD, VDT syndromes, circulatory problems, cancer, and gene mutants.

The present invention has an economic effect in that it creates new big market by new products that prevent the threat of electromagnetic waves from TVs, computers, cellular phones, cordless phones, spectacles, face shields, and screen protectors. What is more important, the present invention helps protect human health so that the tangible and intangible effects combined of the present invention can be considered infinite.

Simple description of drawings

FIG. 1 is a cross-sectional view of an exemplary transparent screen with conventional conductive coating, which is made up of conductive coating 2 on a transparent screen 1;

FIG. 2 is a cross-sectional view of an exemplary thick layer that includes electromagnetic shielding materials where nano particles are dispersed according to the present invention, in which nano powder of ferrite compounds 3 for shielding electromagnetic waves is contained in transparent glass 1;

FIG. 3 is a cross-sectional view of an exemplary thick layer that includes electromagnetic shielding materials where nano particles are dispersed according to the present invention, in which electromagnetic shielding ferrite compounds 3 and nano powder of titanium 4 are contained in the transparent glass 1;

FIG. 4 is a cross-sectional view of exemplary transparent glass 1 to which a thick electromagnetic shielding layer is attached according to the present invention, in which the nano powder of electromagnetic shielding ferrite compounds 3 is contained in the glass 1;

FIG. 5 is a cross-sectional view of an exemplary thick layer that includes electromagnetic shielding materials according to the present invention where nano particles are dispersed in a screen protector, in which the nano powder of electric shielding ferrites 3 and nano powder of magnetic shielding titanium 4 are contained in the conductive and transparent material 5 for the screen protector;

FIG. 6 is a side view of an exemplary bar-type cellular or cordless phone, in which the main body 200 and a screen transparent part 500 of the cellular or cordless phone are made using electromagnetic shielding materials while an exterior cover of an antenna part 100 does not contain electromagnetic shielding materials, enabling transmission of electromagnetic waves for communication;

FIG. 7 is a side view of an exemplary folder-type cellular or cordless phone, in which the front folder 300, the screen 500 and the main body 200 use electromagnetic shielding materials while the rear body 100 does not use electromagnetic shielding materials for the antenna to be set up;

FIG. 8 is a side view of an exemplary cellular or cordless phone of sliding type, in which electromagnetic shielding materials are used for the screen 500, the front part 300 and the main body part 200 where the keypad of the rear body is set while electromagnetic shielding materials are not used for the antenna part 100 on the rear body, enabling the penetration of electromagnetic waves for communication, and plates of ferromagnetic materials such as ferrites or ferrates are used specifically for a sliding part 400;

FIG. 9 is a plan view of the rear part of one of cordless phones or cellular phones including bar types, folder types and sliding types, in which the cover of electromagnetic shielding layer 200 occupies the circumference of the rear body, the electromagnetic penetrating layer 100 having a transmission/reception part occupies the upper center part of the rear body, the electromagnetic penetrating layer 100 may be made small although the electromagnetic penetrating layer 100 can be enlarged to be equal to the electromagnetic shielding layer 200, and the size of electromagnetic penetrating layer 100 may be completely covered by the front screen in the case of sliding types;

FIG. 10 is a side view of one of a variety of cordless phones or cellular phones where an electromagnetic shielding part 700 on the lower part is opened in calling mode, in which the electromagnetic shielding part 700 usually attached to the rear body 200 of the phone is opened manually, automatically or semi-automatically in calling mode in order to shield electromagnetic waves toward user's body.

Best Mode

For the transparent screen part of TVs, computers, cellular phones and cordless phones and for the seeing through part of spectacles, face shields or screen protectors, ferromagnetic materials or ferrimagnetic materials about 10nm in average particle size such as ferrites or ferrates are dispersed and mixed within the screen parts or seeing through parts to sufficiently shield harmful electromagnetic waves while passing visible rays.

For the cases of TVs, computers, cellular phones and cordless phones that do not need to be transparent, the ferromagnetic or ferrimagnetic materials such as ferrites or ferrates that have about 40nm~1.3$\mu$m of particle size less than a single magnetic domain field can be dispersed and mixed within the materials for the case such as synthetic resins or metals, in order to enable efficient shielding upon the whole direction as well as just upon the screen part direction. In addition, for TVs and computers, it is recommended to earth to both of the screen and the case.

In this case, the rear case part of cellular phones or cordless phones where the antenna is set does not adopt electromagnetic shielding materials to enable communication. In the case of sliding-type phones, the sliding part is recommended to adopt ferrites or ferrates material in order to efficiently shield electromagnetic waves.

Mode for Invention

For the transparent screen part of TVs, computers, cellular phones and cordless phones, or the seeing through part of spectacles, face shields and screen protectors, ferromagnetic or ferrimagnetic materials such as ferrites or ferrates of about 10nm $\pm$ 5nm in the average particle size are dispersed and mixed to sufficiently shield harmful electromagnetic waves while leaving visible rays to pass.

For the cases of TVs, computers, cellular phones or the cordless phones that do not need to be transparent, the ferromagnetic or ferrimagnetic materials such as ferrites or ferrates that have about 40nm~1.3$\mu$m of particle size less than a single magnetic domain field can be dispersed and mixed among the materials for the cases such as synthetic resins or metals in order to enable efficient shielding upon the whole direction as well as just upon the screen part direction.

In this case, the rear case part of cellular phones or cordless phones where the antenna is set does not adopt electromagnetic shielding materials to enable communication. Further, in the case of sliding-type phones, the sliding part is recommended to adopt ferrites or ferrates material in order to efficiently shield electromagnetic waves.

Industrial Applicability

The present invention is considered easily available for industrial purposes in that the mass production methods of ferrites of about 11nm in average particle size are already developed, with the mass production technique of nano materials being developed increasingly.

**Claims**

1. A TV screen which shields or reduces harmful electromagnetic waves using a transparent glass material or synthetic resin material for the TV screen, wherein at least one of particle or fiber of metal kind, particle or fiber of metal kind alloys, particle or fiber of metal kind compounds, particle or fiber of ferrite or ferrate, particle or fiber of ferrite or ferrate alloys, particle or fiber of ferrite or ferrate compounds, particle or fiber of carbon, and particle or fiber of fine ceramics as electromagnetic wave shielding materials is blended with the transparent glass material or synthetic resin material for the TV screen, the electromagnetic wave shielding materials containing more than one of ferromagnetic or ferrimagnetic materials and having a particle size in a range between 0.2nm and 200nm.

2. A computer screen which shields or reduces harmful electromagnetic waves using a transparent glass material or synthetic resin material for the computer screen, wherein at least one of particle or fiber of metal kind, particle or fiber of metal kind alloys, particle or fiber of metal kind compounds, particle or fiber of ferrite or ferrate, particle or fiber of ferrite or ferrate alloys, particle or fiber of ferrite or ferrate compounds, particle or fiber of carbon, and particle or fiber of fine ceramics as electromagnetic shielding materials is blended with the transparent glass material or synthetic resin material for the computer screen, the electromagnetic wave shielding materials containing more than one of ferromagnetic or ferrimagnetic materials and having a particle size in a range between 0.2nm and 200nm.

3. A screen protector of a TV or computer, which shields or reduces harmful electromagnetic waves using a transparent glass material or synthetic resin material for the screen protector, wherein at least one of particle or fiber of metal kind, particle or fiber of metal kind alloys, particle or fiber of metal kind compounds, particle or fiber of ferrite or ferrate, particle or fiber of ferrite or ferrate alloys, particle or fiber of ferrite or ferrate compounds, particle or fiber of carbon, and particle or fiber of fine ceramics as an electromagnetic shielding materials is blended with the transparent glass material or synthetic resin material for the screen protector, the electromagnetic wave shielding materials containing more than one of ferromagnetic or ferrimagnetic materials and having a particle size in a range between 0.2nm and 200nm.

4. A cellular phone screen which shields or reduces harmful electromagnetic waves using a transparent glass material or synthetic resin material for the screen, wherein at least one of particle or fiber of metal kind, particle or fiber of metal kind alloys, particle or fiber of metal kind compounds, particle or fiber of ferrite or ferrate, particle or fiber of ferrite or ferrate alloys, particle or fiber of ferrite or ferrate compounds, particle or fiber of carbon, and particle or fiber of fine ceramics as electromagnetic shielding materials is blended with the transparent glass material or synthetic resin material for the screen, the electromagnetic wave shielding materials containing more than one of ferromagnetic or ferrimagnetic materials and having a particle size in a range between 0.2nm and 200nm.

5. A cordless phone screen that shields or reduces harmful electromagnetic waves using a transparent glass material or synthetic resin material for the screen, wherein at least one of particle or fiber of metal kind, particle or fiber of metal kind alloys, particle or fiber of metal kind compounds, particle or fiber of ferrite or ferrate, particle or fiber of ferrite or ferrate alloys, particle or fiber of ferrite or ferrate compounds, particle or fiber of carbon, and particle or fiber of fine ceramics as electromagnetic shielding materials is blended with the transparent glass material or synthetic resin material for the screen, the electromagnetic wave shielding materials containing more than one of ferromagnetic or ferrimagnetic materials and having a particle size in a range between 0.2nm and 200nm.

6. Spectacles which shield or reduce harmful electromagnetic waves using an electromagnetic wave shielding layer made of a transparent glass material or synthetic resin material for the glass lens of the spectacles, wherein at least one of particle or fiber of metal kind, particle or fiber of metal kind alloys, particle or fiber of metal kind compounds, particle or fiber of ferrite or ferrate, particle or fiber of ferrite or ferrate alloys, particle or fiber of ferrite or ferrate compounds, particle or fiber of carbon, and particle or fiber of fine ceramics as electromagnetic shielding materials is blended with the transparent glass material or synthetic resin material for the glass lens of the spectacles, the electromagnetic wave shielding materials containing more than one of ferromagnetic or ferrimagnetic materials and having a particle size in a range between 0.2nm and 200nm.

7. A face shield which shields or reduces harmful electromagnetic waves using a transparent glass material or synthetic resin material for a see-through portion of the face shield, wherein at least one of particle or fiber of metal kind, particle or fiber of metal kind alloys, particle or fiber of metal kind compounds, particle or fiber of ferrite or ferrate, particle or fiber of ferrite or ferrate alloys, particle or fiber of ferrite or ferrate compounds, particle or fiber of carbon, and particle or fiber of fine ceramics as electromagnetic shielding materials is blended with the transparent glass material or synthetic resin material for the see-through portion of the face shield, the electromagnetic wave shielding materials containing more than one of ferromagnetic or ferrimagnetic materials and having a particle size in a range between 0.2nm and 200nm.

8. An ultraviolet-ray shielding method according to one of claims 1 through 7, wherein an ultraviolet-ray shielding material is manufactured by blending at least one of titanium, titanium alloys, titanium compounds, platinum, platinum alloys, platinum compounds, mercury, mercury alloys, and mercury compounds as a particulate or fibrous material having a particle size in a range between 0.2nm and 200nm with a transparent glass or synthetic resin material in order to improve ultraviolet-ray shielding effect.

9. A cellular phone which comprises a case, a sliding plate and a keypad, at least one of which is composed of an electromagnetic wave shielding layer, and shields or reduces harmful electromagnetic waves through the electromagnetic wave shielding layer, wherein at least one of particle or fiber of metal kind, particle or fiber of metal kind alloys, particle or fiber of metal kind compounds, particle or fiber of ferrite or ferrate, particle or fiber of ferrite or ferrate alloys, particle or fiber of ferrite or ferrate compounds, particle or fiber of carbon, and particle or fiber of fine ceramics as electromagnetic shielding materials is blended with a synthetic resin or metal material forming the electromagnetic wave shielding layer, the electromagnetic wave shielding materials containing more than one of ferromagnetic or ferrimagnetic materials.

10. A cordless phone which comprises a case, a sliding plate and a keypad, at least one of which is composed of an electromagnetic wave shielding layer, and shields or reduces harmful electromagnetic waves through the electromagnetic wave shielding layer, wherein at least one of particle or fiber of metal kind, particle or fiber of metal kind alloys, particle or fiber of metal kind compounds, particle or fiber of ferrite or ferrate, particle or fiber of ferrite or ferrate alloys, particle or fiber of ferrite or ferrate compounds, particle or fiber of carbon, and particle or fiber of fine ceramics as electromagnetic shielding materials is blended with a synthetic resin or metal material forming the electromagnetic wave shielding layer, the electromagnetic wave shielding materials containing more than one of ferromagnetic or ferrimagnetic materials.

11. A cellular phone which comprises a case, a sliding plate and a keypad, at least one of which is composed of an electromagnetic wave shielding layer, and shields or reduces electromagnetic waves through the electromagnetic wave shielding layer, wherein ferromagnetic or ferrimagnetic materials that have a single magnetic domain are blended as a main electromagnetic shielding material with a synthetic resin or metal material forming the electromagnetic wave shielding layer to shield electromagnetic waves.

12. A cordless phone which comprises a case, a sliding plate and a keypad, at least one of which is composed of an electromagnetic wave shielding layer, and shields or reduces electromagnetic waves through the electromagnetic wave shielding layer, wherein ferromagnetic or ferrimagnetic materials that have a single magnetic domain are blended as a main electromagnetic shielding material with a synthetic resin or metal material forming the electromagnetic wave shielding layer to shield electromagnetic waves.

13. A method of manufacturing a case of a cellular or cordless phone according to one of claims 9, 10, 11 and 12, wherein the side of the phone facing a user engaged or not engaged in a cell is shielded with an electromagnetic shielding material, while a part or all of the antenna area on the rear side of the phone is not shielded with an electromagnetic shielding material to enable transmission/receiving, to thereby prevent electromagnetic waves from harming the user.

14. A cellular phone having a sliding plate that corresponds to the boundary between the front and rear sides of the cellular phone and is composed of an electromagnetic wave shielding layer formed of ferrites or ferrates, or ferrite or ferrate alloys to shield electromagnetic waves on the sliding plate.

15. A cordless phone having a sliding plate that corresponds to the boundary between the front and rear sides of the cordless phone and is composed of an electromagnetic wave shielding layer formed of ferrites or ferrates, or ferrite or ferrate alloys to shield electromagnetic waves on the sliding plate.

Figure 1

Figure 2

Figure 3

Figure 4

Figure 5

Figure 6

500 ← → 100

→ 200

Figure 7

500 ← → 100

300 ← → 200

Figure 8

→ 400

500 ←

→ 100

300 ←

→ 200

Figure 9

→ 100

→ 200

Figure 10

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2020040028913 A
- WO 2020050010399 A
- KR 1020050008292
- WO 1020050008292 A

**Non-patent literature cited in the description**

- Electromagnetic Waves That Threat You. HanSeung, 30 May 1997